# EUROPEAN PATENT SPECIFICATION

(11) **EP 0 982 974 B1**
(45) Date of publication and mention of the grant of the patent: **03.05.2006**
(21) Application number: 98941685.4
(22) Date of filing: 02.09.1998
(51) Int. Cl.: H05B 33/10, H05B 33/22, C08L 101/00, C08K 5/05

(54) **ORGANIC EL ELEMENT MANUFACTURING PROCESS**
VERFAHREN ZUR HERSTELLUNG EINER ORGANISCHEN ELEKTROLUMINESZENTEN VORRICHTUNG
PROCEDE DE FABRICATION D'UN ELEMENT ELECTROLUMINESCENT ORGANIQUE

(30) Priority: 02.09.1997 JP 23710397; 29.07.1998 JP 21459698
(43) Date of publication of application: 01.03.2000
(60) Divisional application: 03077454.1
(73) Proprietor: SEIKO EPSON CORPORATION, Shinjuku-ku, Tokyo 163-0811 (JP)
(72) Inventor: SEKI, Shunichi, Seiko Epson Corporation, Suwa-shi, Nagano-ken 392-8502 (JP); KIGUCHI, Hiroshi, Seiko Epson Corporation, Suwa-shi, Nagano-ken 392-8502 (JP)
(74) Representative: Sturt, Clifford Mark
(86) International application number: PCT/JP1998/003935
(87) International publication number: WO 1999/012395

(56) References cited:
- EP-A- 0 758 671
- WO-A-97/32452
- JP-A- 1 204 977
- JP-A- 4 170 478
- JP-A- 6 136 306
- JP-A- 7 235 378
- JP-A- 10 012 377
- JP-A- 10 153 967
- US-A- 4 659 676
- HTTP://HOME.WXS.NL/-SKOK/TECHNIQUES/HPLC/E LUOTROPIC_SERIES_EXTENDED.HTML

## Description

### Technical Field

The present invention relates to a manufacturing process for an organic EL (electroluminescence) element.

### BACKGROUND ART

When electric charge is applied to a solid thin film containing a fluorescent organic molecule and sandwiched between electrodes, holes (holes) are injected from the anode and electrons from the cathode, these carriers moving through the thin film due to the applied electric field, and recombining. An element in which the energy released during this recombination is consumed in the formation of a singlet excitation state of the fluorescent molecule (molecule exciton), and the fluorescence emitted with relaxation of the singlet exciton to ground state is utilized is an organic EL element.

Apropos, with a single-layer type structure element comprising a light-emitting layer only, light emission efficiency is low and there are problems with durability, and therefore a two-layer type structure element provided with a hole injecting and transporting layer with good contact situated between the anode and the light-emitting layer has been proposed. Through the use of a stacked structure to control carrier injection/transport balance and carrier recombination location, EL light-emitting element light emission efficiency and durability can be improved. Further, according to a stacked structure, the functions of light emission and injection/transport can be carried out by separate materials, which provides the advantage of making possible optimal design of materials and elements.

In the past, as hole injecting and transporting layer compounds for two-layer stacked type organic EL elements, there have been proposed in the past a porphyrinic compound (US Patents 4,356,429 and 4,720,432), aniline, pyridine, and low-molecular weight derivatives thereof (Unexamined Patent Application (Kokai) 3-34382), hole injecting and transporting layers using carbon layers (Unexamined Patent Application (Kokai) 8-31573), etc. The formation of hole injecting and transporting layers using these low-molecular weight materials is usually accomplished by film formation methods involving vacuum deposition or sputtering. Polyaniline (Nature, 357, 477 (1992), etc. is known as a low-molecular weight materials, film formation being carried out by a wet process such as spin coating, etc.

However, film formation methods involving vacuum deposition or sputtering are batch processes having extended time periods, and thus mass production efficiency is poor. In the case of low-molecular weight materials, there are the problems of susceptibility to crystallization after film formation and lower element reliability. On the other hand, in the case of high-molecular weight materials, there are the advantages of a high degree of freedom in molecular design, and ease of optimization of materials owing to a wet process; however, film formation methods such as spin coating, etc., have a big problem in that virtually all of the material is wasted.

In cases where fine patterning of materials is required, as in full-color displays, etc., there are the fundamental problems that high-precision patterning is difficult in deposition processes, while the materials lack durability against patterning processes involving photolithography. The same problems exist in the case of high-molecular weight materials as well. The materials used as hole injecting and transporting layers or buffer layers are conductive, and thus if complete patterning cannot be realized, this can result in leakage current between adjacent pixels located on a given substrate.

### DISCLOSURE OF THE INVENTION

According to the present invention, there is provided a manufacturing process for an organic EL element having a stacked structure including a hole injecting or transporting layer and a light-emitting layer formed within a partitioning member which is divided into individual pixel areas, the process comprising:
forming an anode layer;
forming a partitioning member above a substrate, the partitioning member having openings over at least a portion of the anode layer, the openings corresponding to the pixel areas;
forming a hole injecting or transporting layer by filling each of the openings with a composition for the hole injecting or transporting layer using an ink-jet type recording head, the composition comprising:
   a conductive compound for the hole injecting or transporting layer wherein the compound has a lower ionization potential than the anode layer; and at least one kind of polar solvent; and
   drying the composition with which the openings are filled to form the hole injecting or transporting layer.

Preferably, the process further comprises filling each of the openings with a light-emitting layer composition by using an ink-jet type recording head to form the light-emitting layer.

Preferably, the process further comprises forming a cathode layer over the light-emitting layer.

Preferably, the compound is selected from the group consisting of a porphyrinic compound, polyaniline and polyethylene dioxythiophene.

Preferably, the compound is present in a dissolved or dispersed state in at least one kind of polar solvent.

Preferably, the polar solvent is methanol or ethanol, or the polar solvent is a mixed solvent of water and a Cellosolve solvent. If a Cellosolve solvent is used, it is preferred that the Cellosolve solvent is ethoxyethanol.

Preferably, the composition further comprises a lubricant, which is preferably glycerin.

Through this method, hole injecting and transporting layer film thickness, dot count, and other parameters may be controlled in a desired manner, allowing the size and pattern of the organic EL element to be established in a desired manner as well.

### BRIEF DESCRIPTION OF THE DRAWINGS

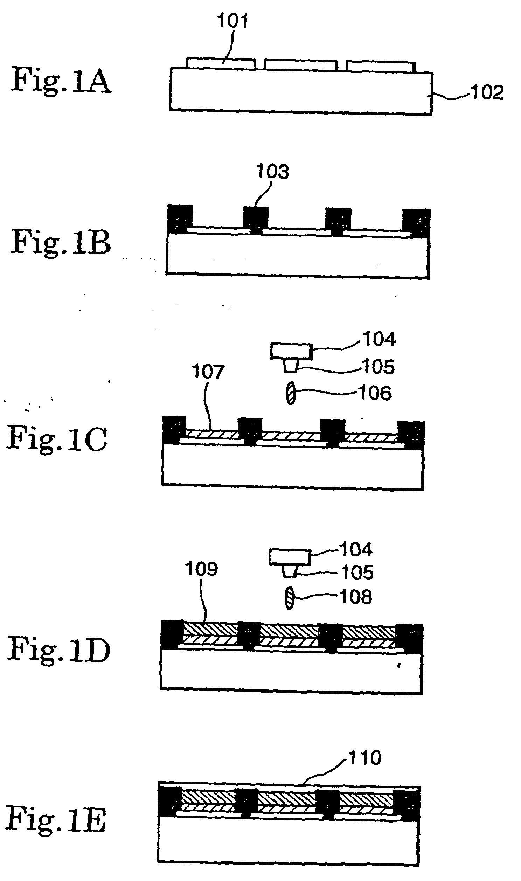

Fig. 1 is a sectional view of manufacturing steps for an organic EL element.

### BEST MODE FOR CARRYING OUT THE INVENTION

Embodiment of Invention 1.

A composition for a hole injecting and transporting layer, organic EL element manufacturing process, and organic EL element pertaining to an aspect of the present embodiment is described below.

The composition for a hole injecting and transporting layer principally contains a conductive compound for forming the hole injecting and transporting layer, a dispersant solvent, and a lubricant, and is used for pattern film formation through an ink-jet system. In preferred practice, the conductive compound for forming the hole injecting and transporting layer is a compound having lower ionization potential than the anode. For example, where ITO is used for the anode, examples of low-molecular weight materials would include copper phthalocyanine and other porphyrinic compounds.

Other additives, as well as film stabilizing materials, may be added as well; for example, viscosity modifiers, antioxidants, pH modifiers, preservatives, resin emulsions, leveling agents, etc., may be used.

### (Example)

Using copper phthalocyanine as the conductive compound (hole injecting and transporting layer component), the physical characteristics of compositions for a hole injecting and transporting layer [produced therefrom] were studied. Composition 1 through Composition 10, given in Table 1 through Table 10, were prepared as specimens.

**Table 1 Composition 1**

| | Ingredient | Content |
|---|---|---|
| | | (wt%) |
| Hole injecting and | copper phthalocyanine (10 wt%) | 25 |
| transporting layer | (styrene acrylic resin | |
| Component | dispersion) | |
| Polar solvent | water | 70 |
| Lubricant | glycerin | 5 |

**Table 2 Composition 2**

| | Ingredient | Content |
|---|---|---|
| | | (wt%) |
| Hole injecting | copper phthalocyanine (10 | 25 |
| and transporting layer | wt%)(styrene acrylic resin | |
| component | dispersion) | |
| Polar solvent | water | 65 |
| | methanol | 5 |
| Lubricant | glycerin | 5 |

**Table 3 Composition 3**

| | Ingredient | Content |
|---|---|---|
| | | (wt%) |
| Hole injecting and | copper phthalocyanine (10 wt%) | 25 |
| transporting layer | (styrene acrylic resin | |
| Component | dispersion) | |
| Polar solvent | water | 65 |
| | ethoxy ethanol | 5 |
| Lubricant | glycerin | 5 |

**Table 4 Composition 4**

| | Ingredient | Content |
|---|---|---|
| | | (wt%) |
| Hole injecting and | copper phthalocyanine (10 wt%) | 25 |
| transporting layer | (styrene acrylic resin | |
| Component | dispersion) | |
| Polar solvent | methanol | 70 |
| Lubricant | glycerin | 5 |

**Table 5 Composition 5**

| | Ingredient | Content |
|---|---|---|
| | | (wt%) |
| Hole injecting and | copper phthalocyanine (10 wt%) | 25 |
| transporting layer | (styrene acrylic resin | |
| Component | dispersion) | |
| Polar solvent | N, N-methyl formamide | 70 |
| Lubricant | glycerin | 5 |

**Table 6 Composition 6**

| | Ingredient | Content |
|---|---|---|
| | | (wt%) |
| Hole injecting and | copper phthalocyanine (10 wt%) | 25 |
| transporting layer | (styrene acrylic resin | |
| Component | dispersion) | |
| Polar solvent | water | 70 |
| Lubricant | -- | 0 |

**Table 7 Composition 7**

| | Ingredient | Content |
|---|---|---|
| | | (wt%) |
| Hole injecting and | copper phthalocyanine (10 wt%) | 25 |
| transporting layer | (styrene acrylic resin | |
| Component | dispersion) | |
| Polar solvent | water | 70 |
| | methanol | 5 |
| Lubricant | -- | 0 |

**Table 8 Composition 8**

| | Ingredient | Content |
|---|---|---|
| | | (wt%) |
| Hole injecting and | copper phthalocyanine (10 wt%) | 25 |
| transporting layer | (styrene acrylic resin | |
| Component | dispersion) | |
| Polar solvent | water | 70 |
| | ethoxy ethanol | 5 |
| Lubricant | -- | 0 |

**Table 9 Composition 9**

| | Ingredient | Content |
|---|---|---|
| | | (wt%) |
| Hole injecting and | copper phthalocyanine (10 wt%) | 25 |
| transporting layer | (styrene acrylic resin | |
| Component | dispersion) | |
| Polar solvent | water | 65 |
| | butoxy ethanol | 5 |
| Lubricant | glycerin | 5 |

**Table 10 Composition 10**

| | Ingredient | Content |
|---|---|---|
| | | (wt%) |
| Hole injecting and | copper phthalocyanine (10 wt%) | 25 |
| transporting layer | (styrene acrylic resin | |
| Component | dispersion) | |
| Polar solvent | water | 65 |
| | isopropyl alcohol | 5 |
| Lubricant | glycerin | 5 |

### (Discharge Evaluation)

Composition 1 through Composition 8, given in Table 1 through Table 8, were measured for contact angle with respect to the nozzle face constituent material constituting the ink-jet type recording head, viscosity, and surface tension, and the discharge properties thereof were evaluated. The discharge evaluation was conducted using an ink-jet printing device (Epson MJ-500C).

Viscosity [is expressed as] measured values at 20°C. These results are given in Table 11.

**Table 11**

| Composition | Contact angle | Viscosity | Surface | Discharge |
|---|---|---|---|---|
| | [°] | [cps] | tension | properties |
| | | | [dyne/cm] | |
| 1 | 135 | 3.8 | 62.8 | ○ |
| 2 | 91 | 3.6 | 40.8 | ○ |
| 3 | 62 | 3.1 | 39.8 | ⊚ |
| 4 | 22 | 0.8 | 23.1 | X |
| 5 | 175 | 0.9 | 81.0 | X |
| 6 | 118 | 1.1 | 71.0 | X |
| 7 | 28 | 0.8 | 68.8 | X |
| 8 | 27 | 0.9 | 69.2 | X |

From these results, it will be apparent that a contact angle of 30° to 170°, and especially 35° to 65°, is preferred. Further, viscosity of 1 cps to 20 cps, and especially 2 cps to 4 cps is preferred, and surface tension of 20 dyne/cm to 70 dyne/cm, and especially the range 25 dyne/cm to 40 dyne/cm, is preferred.

Composition 1 through Composition 3, which contain glycerin as a lubricant, when compared to Composition 6 through Composition 8, which do not contain a lubricant, may be seen to be superior in terms of discharge properties. Accordingly, in preferred practice, the ink composition will contain a lubricant. The inclusion of a lubricant can effectively prevent drying and solidification of the ink composition in the nozzle mouth. Examples of the lubricant are glycerin, diethylene glycol, and other polyhydric alcohols; glycerin is especially preferred.

### (Manufacturing process for composition for a hole injecting and transporting layer)

Composition 1 through Composition 3, Composition 9, and Composition 10 given in Table 1 through Table 3, Table 9, and Table 10, respectively, were manufactured, and the particle size distribution of the hole injecting and transporting layer-forming compound (copper phthalocyanine) was measured before and after a sonication. Using the preceding compositions for a hole injecting and transporting layer having been passed through a filtration step subsequent to the sonication , the film forming properties of hole injecting and transporting layers formed through ink-jet system patterning were evaluated.

These results are given in Table 12. Sonication results are expressed as the proportion of the particle size distribution of 1 µm or smaller.

Particle size in the styrene acrylic resin dispersion was 1 µm or above.

**Table 12**

| Composition | 1 µm particle size proportion (%) | | Film forming |
|---|---|---|---|
| | | | properties |
| | before | after sonication | |
| | sonication | | |
| 1 | 4.8 | 46.8 | ○ |
| 2 | 2.8 | 31.4 | ○ |
| 3 | 4.2 | 43.5 | ⊚ |
| 9 | 2.5 | 18.5 | X |
| 10 | 3.9 | 18.2 | X |

From the preceding results, it will be apparent that 4-hour sonication of the dispersion can increase dispersion. Further, by additionally filtering the sonicated dispersion, it is possible to achieve a more homogeneous hole injecting and transporting layer film. As the dispersant polar solvent for the conductive compound, water or a mixed solvent of water and methanol or ethoxy ethanol is preferred (Composition 1 through Composition 3); it will be apparent that, where these solvents are used, film forming properties are good.

### (Organic EL element manufacturing steps)

Using Composition 1 through Composition 3 given in Table 1 through Table 3, patterning film formation of hole injecting and transporting layers by an ink-jet system was carried out by the following procedure to manufacture organic EL elements.

### Anode formation step (Fig. 1A)

The present step is a step for forming an anode 101 on a glass substrate 102. In preferred practice, glass substrate 102 will be one that resists attack by chemicals such as acids, alkalis, etc., and that is mass-producible. An ITO transparent electrode was formed to a thickness of 0.1 µm on substrate 102 and patterned at 100 µm pitch.

### Partitioning member formation step (Fig. 1B)

The present step is a step for forming a partitioning member 103 on glass substrate 102. Specifically, non-photosensitive polyimide (partitioning member) buried between anodes (ITO electrodes) and also serving as an ink drip prevention wall (bank) was formed by photolithography. The non-photosensitive polyimide was 20 µm wide and 2.0 µm thick.

### Composition for a hole injecting and transporting layer discharge step (Fig. 1C)

Hole injecting and transporting layer Compositions 1 through 3 (106 in the drawing) were discharged from the head 105 of an ink-jet printing device (Epson MJ-800C) 104 to effect patterning film formation of a hole injecting and transporting layer 107. After patterning film formation, a hole injecting and transporting layer was formed through a drying treatment (200°C, 10 min). During discharge of the composition for a hole injecting and transporting layer, no bank-overflowing application was observed, and a high-precision hole injecting and transporting layer pattern was achieved.

### Light-emitting layer composition filling step (Fig. 1D)

Next, a PPV precursor (poly(para-phenylene vinylene)) composition was manufactured as a green light-emitting layer. A light-emitting layer composition 108 was discharged by an ink-jet system to effect patterning film formation of a light-emitting layer 109. Rhodamine B-doped PPV, which exhibits red light emission, or coumarin-doped PPV, which exhibits blue light emission, could be used for the light-emitting layer 109 as well. Light-emitting layers exhibiting light emission of the three primary colors (red, green, blue) can be subjected to patterning over a hole injecting and transporting layer to produce a highly detailed full-color organic EL display.

### Cathode formation step (Fig. 1E)

Finally, a cathode 100 was deposited so as to cover the light-emitting layer 109, forming an organic EL element.

### (Hole injecting and transporting layer film formation evaluation)

In the organic EL element manufacturing steps described above, the number of discharges of the composition for a hole injecting and transporting layer was varied, and the hole injecting and transporting layer film thickness and sheet resistance were measured, as well as evaluating film formation. Results are given in Table 13.

**Table 13**

| Compo- | Discharge | Film | Resistance | Film- | Luminance |
|---|---|---|---|---|---|
| sition | no. | thickness | [Ω/m²] | forming | [cd/m²] |
| | | [µm] | | properties | |
| 1 1 | | 0.05 | 5.0 × 10⁹ | O | 2000 |
| | 3 | 0.14 | 1.7 × 10⁹ | O | 1900 |
| | 5 | 0.26 | 0.9 × 10⁹ | X | 1600 |
| 2 | 1 | 0.03 | 0.7 × 10⁹ | ⊚ | 2000 |
| | 3 | 0.1 | 0.2 × 10⁹ | X | 1500 |
| | 5 | 0.14 | 0.1 × 10⁹ | X | 1500 |
| 3 | 1 | 0.02 | 0.5 × 10⁹ | ⊚ | 2000 |
| | 3 | 0.06 | 0.2 × 10⁹ | ○ | 1800 |
| | 5 | 0.1 | 0.1 × 10⁹ | X | 1400 |

From these results, it will be apparent that in the case of a low-molecular weight material, where the hole injecting and transporting layer film thickness is 0.05 µm or smaller and film resistance is from 0.5 × 10⁹ Ω/m² to 5 × 10⁹ Ω/m², light-emission characteristics are good.

### (Effect)

According to the present aspect of the embodiment, fine patterning can be realized easily, in a short time, and at low cost. Accordingly, there is no risk of leakage due to the hole injecting and transporting layer itself, a problem that could not be solved in solid film formation methods. Further, since film thickness can be readily controlled through manipulation of the discharge amount or number of discharges, optimization of thin film design thereby is possible.

### Aspect of Embodiment of the Invention 2.

The present aspect of embodiment is one in which the conductive compound for forming the hole injecting and transporting layer is a material capable of forming a film from solution (high-molecular weight material), and is one that employs polyaniline, polysilane, or other conductive high-molecular weight material. In particular, as water can be used as the principal solvent, and as characteristics can be adjusted through the mixture ratio, a mixed material of PEDT (polyethylene dioxythiophene) 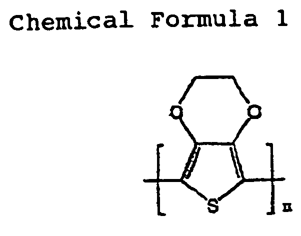 and PSS (polystyrene sulfonic acid) 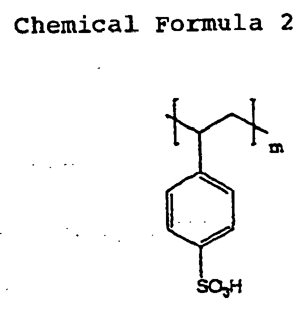 is preferred.

### (Example)

compositions for a hole injecting and transporting layer prepared using a PEDT/PSS mixture aqueous solution as the high-molecular weight material (hole injecting and transporting layer component) were prepared in the five varieties (Composition 11 through Composition 15) given in Table 14 through Table 18.

**Table 14 Composition 11**

| Composition | Material name | Content |
|---|---|---|
| | | (wt%) |
| Hole injecting and | PEDT/PSS mixture aqueous | 20 |
| transporting layer | dispersion(1.0 wt%) | |
| component | | |
| Polar solvent | water | 80 |
| Lubricant | -- | 0 |

**Table 15 Composition 12**

| Composition | Material name | Content |
|---|---|---|
| | | (wt%) |
| Hole injecting and | PEDT/PSS mixture aqueous | 20 |
| transporting layer | dispersion(1.0 wt%) | |
| component | | |
| Polar solvent | N,N-dimethyl formamide | 75 |
| Lubricant | glycerin | 5 |

**Table 16 Composition 13**

| Composition | Material name | Content |
|---|---|---|
| | | (wt%) |
| Hole injecting and | PEDT/PSS mixture aqueous | 20 |
| transporting layer | dispersion(1.0 wt%) | |
| component | | |
| Polar solvent | water | 75 |
| Lubricant | glycerin | 55 |

**Table 17 Composition 14**

| Composition | Material name | Content |
|---|---|---|
| | | (wt%) |
| Hole injecting and | PEDT/PSS mixture aqueous | 20 |
| transporting layer | dispersion(1.0 wt%) | |
| component | | |
| Polar solvent | water | 70 |
| | methanol | 5 |
| Lubricant | glycerin | 5 |

**Table 18 Composition 15**

| Composition | Material name | Content |
|---|---|---|
| | | (wt%) |
| Hole injecting and | PEDT/PSS mixture aqueous | 20 |
| transporting layer | dispersion(1.0 wt%) | |
| component | | |
| Polar solvent | water | 65 |
| | ethoxy ethanol | 10 |
| Lubricant | glycerin | 5 |

Discharge evaluations were conducted using an ink-jet printing device (Epson MJ-800C). Film-forming properties evaluations were conducted in film state after a heating treatment (200°C, 10-60 min) conducted after application through discharge. Viscosity [is expressed as] measured values at 20°C.

**Table 19**

| Composition | Contact | Viscosi | Surface | Discharge | Film- |
|---|---|---|---|---|---|
| | angle[°] | [cps] | tension | properties | forming |
| | | | [dyne/cm] | | properties |
| 1 | 130 | 1.2 | 73.0 | X | - |
| 2 | 63 | 0.9 | 38.5 | X | - |
| 3 | 120 | 4.5 | 68.0 | O | Δ |
| 4 | 84 | 4.0 | 62.3 | ⊚ | O |
| 5 | 64 | 3.5 | 40.0 | ⊚ | ⊚ |

From the preceding results, it will be apparent that the concentration of the conductive high-molecular weight material is preferably 0.01 wt%-10.0 wt% based on the entire composition, and especially preferably 0.1 wt%-5.0 wt%. The reason is that if the conductive high-molecular weight material concentration is too low, a large number of discharges will be needed to produce the required film thickness, and mass-production efficiency will be poor, while on the other hand, if the conductive high-molecular weight material concentration is too high, viscosity will be higher.

In preferred practice, the composition for a hole injecting and transporting layer will contain a lubricant. This can effectively prevent drying and solidification of the ink composition in the ink-jet nozzle mouth. Examples of the lubricant are glycerin, diethylene glycol, and other polyhydric alcohols; glycerin is especially preferred. In preferred practice, the added amount of lubricant is equivalent to about 5 wt%-20 wt% based on the entire composition.

In preferred practice, water, a mixed solvent of water and a lower alcohol, or a mixed solvent of water and a Cellosolve solvent will be used as the polar solvent used for the composition for a hole injecting and transporting layer. The use of these solvents makes it possible to adjust the contact angle of the composition for a hole injecting and transporting layer with respect to the material of the nozzle face of the ink-jet head, the viscosity, and the surface tension without any loss of solubility or dispersibility of the conductive compound. Methanol or ethanol is preferred as the lower alcohol. From the standpoint of film-forming properties, ethoxy ethanol is preferred as the Cellosolve solvent.

Other additives, as well as film stabilizing materials, may be added as well; for example, viscosity modifiers, antioxidants, pH modifiers, preservatives, resin emulsions, leveling agents, etc., may be used.

### (Manufacturing process for composition for a hole injecting and transporting layer)

A comparison of film-forming properties and light emission characteristics with and without sonication and a filtration step was conducted using the composition for a hole injecting and transporting layer (Composition 15) given in Table 18, and is given in Table 7. PPV (poly(para-phenylene vinylene)) was used as a green light-emitting layer.

**Table 20**

| Step | | Film | luminance | light | light |
|---|---|---|---|---|---|
| | | quality | [cd/m²] | emission | emission |
| | | | | initial | lifetime |
| | | | | voltage[V^{th}] | [hr] |
| sonication | yes | ⊚ | 2000 | 3.0 | 5000 |
| step and | no | Δ | 1000 | 5.0 | 500 |
| filtration step | | | | | |

As will be apparent from the preceding results, conducting sonication increases the dispersion, and the use of a composition prepared by filtration of a sonicated dispersion affords a homogeneous hole injecting and transporting layer that has good flatness. In preferred practice, film thickness is 0.05 µm-0.1 µm. The reason is that the film-forming properties of the hole injecting and transporting layer affect the light emission characteristics of the element.

The manufacturing steps for the organic EL element of the present aspect of embodiment are the same as in Aspect of Embodiment 1.

### INDUSTRIAL APPLICABILITY

According to the present invention, a composition for a hole injecting and transporting layer is prepared as a liquid, thus permitting optimal design of materials, and the liquid composition is prepared as an ink, thus permitting high-precision patterning of a hole injecting and transporting layer by ink-jet system. Further, the use of a conductive compound, particularly a high-molecular weight material, as the hole injecting and transporting layer material affords manufacture of an organic EL element having high reliability and high qualities.

According to the ink-jet system patterning which pertains to the present invention, there is provided simple, low-cost hole injecting and transporting layer formation.

According to the manufacturing process for an organic EL element which pertains to the present invention, film thickness, number of dots, and other parameters can be adjusted in a desired manner, allowing the size and pattern of a light-emitting element to be established in a desired manner as well. Further, by combining light-emitting layers of the three primary colors (red, green, blue) produced through ink-jet system patterning, it is possible to develop a highly detailed full-color display with excellent light emission characteristics.

## Claims

1. A manufacturing process for an organic EL element having a stacked structure including a hole injecting or transporting layer and a light-emitting layer formed within a partitioning member which is divided into individual pixel areas, the process comprising:
forming an anode layer;
forming a partitioning member above a substrate, the partitioning member having openings over at least a portion of the anode layer, the openings corresponding to the pixel areas;
forming a hole injecting or transporting layer by filling each of the openings with a composition for the hole injecting or transporting layer using an ink-jet type recording head, the composition comprising:
a conductive compound for the hole injecting or transporting layer wherein the compound has a lower ionization potential than the anode layer; and at least one kind of polar solvent; and
drying the composition with which the openings are filled to form the hole injecting or transporting layer.

2. A process according to claim 1, further comprising filling each of the openings with a light-emitting layer composition by using an ink-jet type recording head to form the light-emitting layer.

3. A process according to claim 2, further comprising forming a cathode layer over the light-emitting layer.

4. A process according to any one of claims 1 to 3, wherein the compound is selected from the group consisting of a porphyrinic compound, polyaniline and polyethylene dioxythiophene.

5. The process according to any one of claims 1 to 4, wherein the compound is present in a dissolved or dispersed state in at least one kind of polar solvent.

6. A process according to claim 5, wherein the polar solvent is methanol or ethanol.

7. A process according to claim 5. wherein the polar solvent is a mixed solvent of water and a Cellosolve solvent.

8. The process according to claim 7, wherein the Cellosolve solvent is ethoxyethanol.

9. The process according to any one of claims 1 to 8, wherein the composition further comprises a lubricant.

10. The process according to claim 9, wherein the lubricant is glycerin.

## Revendications

1. Procédé de fabrication pour un élément électroluminescent organique ayant une structure en superposition comprenant une couche à injection de trous ou de transport et une couche d'émission de lumière formées dans un élément de séparation partagé en zones de pixels individuelles, le procédé comprenant :
la formation d'une couche d'anode ;
la formation d'un élément de séparation au dessus d'un substrat, l'élément de séparation ayant des ouvertures sur au moins une partie de la couche d'anode, les ouvertures correspondant aux zones de pixels ;
la formation d'une couche à injection de trous ou de transport en remplissant chacune des ouvertures avec un mélange pour la couche à injection de trous ou de transport en utilisant une tête d'enregistrement de type à jet d'encre, le mélange comprenant :
un composé conducteur pour la couche à injection de trous ou de transport, le composé présentant un potentiel de ionisation inférieur à celui de la couche d'anode, et au moins un type de solvant polaire ; et
le séchage du mélange avec lequel les ouvertures sont comblées afin de former la couche à injection de trous ou de transport.

2. Procédé selon la revendication 1, comprenant en outre le remplissage de chacune des ouvertures avec un mélange de couche d'émission de lumière en utilisant une tête d'enregistrement de type à jet d'encre afin de former la couche d'émission de lumière.

3. Procédé selon la revendication 2, comprenant en outre la formation d'une couche de cathode sur la couche d'émission de lumière.

4. Procédé selon l'une quelconque des revendications 1 à 3, où le composé est sélectionné dans le groupe formé par un composé à base de porphyrine, du polyaniline et du polyéthylène dioxythiophène.

5. Procédé selon l'une quelconque des revendications 1 à 4, où le composé est présent à l'état de dissolution ou de dispersion dans au moins un type de solvant polaire.

6. Procédé selon la revendication 5, où le solvant polaire est du méthanol ou de l'éthanol.

7. Procédé selon la revendication 5, où le solvant polaire est un solvant mélangé à base d'eau et un solvant de glycol d'éthyle.

8. Procédé selon la revendication 7, où le solvant de glycol d'éthyle est de l'éthoxyéthanol.

9. Procédé selon l'une quelconque des revendications 1 à 8, où le mélange comprend par ailleurs un lubrifiant.

10. Procédé selon la revendication 9, ou le lubrifiant est de la glycérine.

## Patentansprüche

1. Verfahren zur Herstellung einer organischen EL-Vorrichtung mit einer gestapelten Struktur, enthaltend eine Löcherinjektions- oder -transportschicht und eine lichtemittierende Schicht, die in einem Trennelement gebildet ist, das in einzelne Pixelflächen geteilt ist, wobei das Verfahren umfasst:
Bilden einer Anodenschicht;
Bilden eines Trennelements über einem Substrat, wobei das Trennelement Öffnungen über mindestens einem Teil der Anodenschicht hat, wobei die Öffnungen den Pixelflächen entsprechen;
Bilden einer Löcherinjektions- oder -transportschicht durch Füllen jeder der Öffnungen mit einer Zusammensetzung für die Löcherinjektions- oder -transportschicht unter Verwendung eines Aufzeichnungskopfs vom Tintenstrahltyp, wobei die Zusammensetzung umfasst:
eine leitende Verbindung für die Löcherinjektions- oder -transportschicht, wobei die Verbindung ein geringeres Ionisierungspotenzial als die Anodenschicht hat, und mindestens eine Art von polarem Lösemittel; und
Trocknen der Zusammensetzung, mit der die Öffnungen gefüllt sind, um die Löcherinjektions- oder -transportschicht zu bilden.

2. Verfahren nach Anspruch 1, des Weiteren umfassend das Füllen jeder der Öffnungen mit einer lichtemittierenden Schichtzusammensetzung unter Verwendung eines Aufzeichnungskopfs vom Tintenstrahltyp zur Bildung der lichtemittierenden Schicht.

3. Verfahren nach Anspruch 2, des Weiteren umfassend eine Kathodenschicht über der lichtemittierenden Schicht.

4. Verfahren nach einem der Ansprüche 1 bis 3, wobei die Verbindung ausgewählt ist aus der Gruppe bestehend aus einer porphyrinischen Verbindung, Polyanilin und Polyethylendioxythiophen.

5. Verfahren nach einem der Ansprüche 1 bis 4, wobei die Verbindung in einem gelösten oder dispergierten Zustand in mindestens einer Art von polarem Lösemittel vorhanden ist.

6. Verfahren nach Anspruch 5, wobei das polare Lösemittel Methanol oder Ethanol ist.

7. Verfahren nach Anspruch 5, wobei das polare Lösemittel ein gemischtes Lösemittel aus Wasser und einem Cellosolve-Lösemittel ist.

8. Verfahren nach Anspruch 7, wobei das Cellosolve-Lösemittel Ethoxyethanol ist.

9. Verfahren nach einem der Ansprüche 1 bis 8, wobei die Zusammensetzung des Weiteren ein Schmiermittel umfasst.

10. Verfahren nach Anspruch 9, wobei das Schmiermittel Glycerin ist.
